# EUROPEAN PATENT APPLICATION

(11) **EP 3 780 917 A1**
(43) Date of publication of application: **17.02.2021**
(21) Application number: 19785245.2
(22) Date of filing: 01.04.2019
(51) Int. Cl.: H05K 3/20, C04B 37/02, H01L 23/12, H05K 3/00

(54) **CERAMICS-METAL BONDED BODY AND METHOD OF MANUFACTURING SAME, AND MULTI-PIECE CERAMICS-METAL BONDED BODY AND METHOD OF MANUFACTURING SAME**

(30) Priority: 09.04.2018 JP 2018074477
(71) Applicant: Mitsubishi Materials Corporation, Chiyoda-ku Tokyo 100-8117 (JP)
(72) Inventor: ARAI, Koya, Saitama-shi, Saitama 330-8508 (JP); KOMASAKI, Masahito, Saitama-shi, Saitama 330-8508 (JP)
(74) Representative: Hoffmann Eitle
(86) International application number: PCT/JP2019/014430
(87) International publication number: WO 2019/198551

(57) **Abstract**

A method of manufacturing a ceramics-metal bonded body according to the present invention is a method of manufacturing a ceramics-metal bonded body in which a metal layer is bonded to at least one surface of a ceramics substrate, and comprises: a groove-forming step of forming a groove extending across a bonding region of a ceramics substrate to which a metal layer is bonded; and a bonding step of, after the groove-forming step, forming a metal layer by stacking, in the bonding region of the ceramics substrate, a metal plate of an aluminum or aluminum alloy with a thickness of less than or equal to 0.4 mm, via an Al-Si based brazing material foil, and bonding the metal plate to the bonding region by heating while applying load in a stacking direction.

## Description

### BACKGROUND OF THE INVENTION

### Technical Field

The present invention relates to a method of manufacturing a ceramic-metal joined body in which a metal layer made of aluminum or aluminum alloy is joined on a ceramic substrate board, a method of manufacturing a multi-piece ceramic-metal joined body, a ceramic-metal joined body, and a multi-piece ceramic-metal joined body. Priority is claimed on Japanese Patent Application No. 2018-074477, filed April 9, 2018, the content of which is incorporated herein by reference.

### Background Art

Conventionally, it is proposed to use a ceramic circuit substrate board which is separated into a piece from a ceramic-metal joined body in which metal layers are joined on both surfaces of a ceramic board as a wiring substrate board of a thermoelectric element and an LED element. In this ceramic-metal joined body, a metal board forming the metal layer and the ceramic board are joined by brazing material. For example, Patent Document 1 discloses a method of producing a power module substrate board as a technique of joining a ceramic board and a metal board with brazing material.

In this method of producing the power module substrate board disclosed in Patent Document 1, the respective power module substrate boards are produced by forming a scribe line (a dividing groove) in advance to separate a ceramic base board into a size of the power module substrate board by radiating laser light on a surface of the ceramic base board having a large area on which a plurality of the power module substrate boards can be formed, bonding metal boards made of aluminum or aluminum alloy on both surfaces of the ceramic base board with Al-Si type brazing material, etching the metal parts on the scribe line to remove, and then separating the ceramic substrate board along the scribe line into pieces. Both surfaces of a laminate body of the ceramic base board and the metal boards which are provided on both the surfaces with brazing material therebetween is pressed and heated between carbon boards when it is joined.

### Citation List

### Patent Literature

Patent Document 1: Japanese Unexamined Patent Application, First Publication No. 2015-185606

### SUMMARY OF INVENTION

### Technical Problem

In a case in which the metal layer joined on the ceramic substrate board is thin, the brazing material may be melted on the surface of the metal layer if the laminate body is pressed and heated between the carbon boards, and may be a stain; furthermore, in an extreme case, there may be a problem in that the carbon boards are adhered on the metal layer of the ceramic substrate board.

Therefore, a ceramic-metal joined body and a method of producing thereof are desired to be possible to restrain the braze stain on the surface of the metal layer joined on the ceramic substrate board.

Moreover, in a case in which a plurality of metal layers are formed by etching the metal boards joined on both the surfaces of the ceramic substrate board, it is required that etching rates are substantially the same on both the surfaces in order to simplify a producing process.

The present invention is achieved in consideration of the above circumstances, and has an object to control the etching rates on the metal boards joined on the surfaces of the ceramic substrate board and to reduce generation of the braze stain made on the surface of the metal layer joined on the ceramic substrate board.

### Solution to Problem

A method of manufacturing a ceramic-metal joined body according to the present invention is
a method of manufacturing a ceramic-metal joined body in which a metal layer is joined on at least one surface of a ceramic substrate board, including a groove-forming step forming a groove across a bonding region in which the metal layer is joined on the ceramic substrate board, and a joining step after the groove-forming step in which the metal layer is formed by layering a metal board made of aluminum or aluminum alloy having a thickness of 0.4 mm or less on the bonding region of the ceramic substrate board with interposing an Al-Si type brazing material foil, and heating with adding a load in a laminate direction to bond the metal board on the bonding region.

In other words, it is a method of manufacturing a ceramic-metal joined body having a groove-forming step forming a groove to extend across a bonding region on which a metal layer is joined, where the bonding region is set on at least one surface of a ceramic substrate board, and a joining step to form the metal layer after the groove-forming step, by layering a metal board made of aluminum or aluminum alloy having a thickness of 0.4 mm or less on the bonding region of the ceramic substrate board with interposing an Al-Si type brazing material foil and by heating with adding a load in a laminate direction to join the metal board on the bonding region.

If the metal board made of aluminum or aluminum alloy is layered on a bonding region of a ceramic substrate board on which the groove is not formed with interposing the Al-Si type brazing material foil and heated with adding a load in the laminate direction, Si component included in the melted brazing material diffused to a surface of the metal layer if the thickness of the metal layer is thin as 0.4 mm or less, and it results in generating liquid phase and braze stains at the surface.

By contrast, in the present invention, since the groove is formed on the ceramic substrate board to extend across the bonding region of the ceramic substrate board on which the metal layer is joined, when a laminate body in which the metal board is layered on the bonding region of the ceramic substrate board with the Al-Si type brazing material foil therebetween is heated with adding the load in the laminate direction to join them, since a surplus of the melted brazing material is discharged outside from the bonding region along the groove formed on the ceramic substrate board, it is possible to prevent the Si component of the melted brazing material from diffusing to the surface of the metal layer, to prevent generation of the liquid phase on the surface of the metal layer, and to prevent the braze stains.

In the method of manufacturing a ceramic-metal joined body according to the present invention, it is preferable that the groove is formed in the groove-forming step so that an open area of the groove in the bonding region be less than 5% of an area of the bonding region.

If the open area of the groove in the bonding region is 5% or less of the bonding region, since the bonding area is reduced, bonding property of the ceramic substrate board and the metal board may be deteriorated.

By contrast, in the above aspect, since the open area of the groove in the bonding region is less than 5% of the area of the bonding region, the metal board and the bonding region of the ceramic substrate board can be firmly joined.

The area of the bonding region and the open area of the groove are areas when the ceramic substrate board on which the groove is formed is viewed from the top.

In the method of manufacturing a ceramic-metal joined body of the present invention, in the groove-forming step, it is preferable that the groove be formed inside a groove-forming region having an area of 80% of the bonding region of the ceramic substrate board, and a center of the groove-forming region coincide with a center of the bonding region.

In other words, in the groove-forming step, it is preferable that the groove be formed in a groove-forming region having a center coinciding with a center of the bonding region and having an area of 80% of an area of the bonding region.

The area of the bonding region is an area when the ceramic substrate board is viewed from the top.

In a case in which the groove formed in the groove-forming step is formed outside the groove-forming region with the area of 80% of the bonding region of the ceramic substrate board, or in a case in which the center of the groove-forming region with the area of 80% of the bonding region does not coincide with the center of the ceramic substrate board, that is, in a case in which the groove is formed across only a vicinity of a peripheral edge of the bonding region of the ceramic substrate board, the melted brazing material cannot easily be discharged from substantially a whole of the bonding region.

By contrast, in the above aspect, since the groove formed in the groove-forming step is formed inside the groove-forming region having the area of 80% of the bonding region of the ceramic substrate board and the center of the groove-forming region coincides with the center of the bonding region, the melted brazing material can be efficiently discharged from substantially the whole of the bonding region, and the braze stains can be more prevented.

In this manufacturing method, Si concentration in the Al-Si type brazing material foil is preferably not less than 5% by mass and not more than 12% by mass.

A method of manufacturing a ceramic-metal joined body for multi-piece of the present invention is a method of manufacturing a ceramic-metal joined body for multi-piece in which a metal layer is joined on at least one surface of a ceramic base board having a size which can be divided into a plurality of ceramic substrates, including a groove-forming step forming a groove to extend across a bonding region of the ceramic base board on which the metal layer is joined and forming a scribe line to divide the ceramic base board and form the ceramic substrate boards; and a joining step forming the metal layer after the groove-forming step, in which a metal board made of aluminum or aluminum alloy having a thickness of 0.4 mm or less is layered on the bonding region of the ceramic base board with interposing an Al-Si type brazing material foil, and the metal board is joined on the bonding region by heating with adding a load in a laminate direction, and the metal board is formed to have a size covering a plurality of regions partitioned by the scribe line.

In other words, it is a manufacturing method including a groove-forming step forming at least one scribe line (a dividing groove) on at least one surface of a ceramic base board to partition the ceramic base board into a plurality of ceramic substrate boards, setting a bonding region of a metal board joined to cover the ceramic substrate boards on at least one surface of the ceramic base board, and forming at least one groove to extend across the bonding region; and a joining step layering a metal board made of aluminum or aluminum alloy which has a thickness of 0.4 mm or less on the bonding region of the ceramic base board with interposing an Al-Si type brazing material foil to cover the bonding region, and heating with adding a load in a laminate direction to join the metal board on the bonding region to form a metal layer.

According to such making, the ceramic-metal joined body for multi-piece can be easily made into pieces along the scribe line (the dividing groove), and the ceramic circuit substrate boards can be efficiently manufactured. Moreover, the braze stains can be reduced since the melted brazing material can be discharged outside the bonding region from both sides of the scribe line and the groove in a case in which the metal board is also joined on the scribe line.

Furthermore, content of Si atoms diffused in the metal layer is reduced since the groove is formed on the ceramic base board and the melted brazing material is discharged outside the bonding region. Accordingly, an etching rate of the ceramic-metal joined body for multi-piece is high, and an etching treatment can be efficiently carried out when the etching treatment is carried out on the ceramic-metal joined body for multi-piece.

In the method of manufacturing a ceramic-metal joined body for multi-piece of the present invention, it is preferable that both surfaces of the ceramic base board have the bonding region and the scribe line be formed on one surface of the ceramic base board and the groove be formed on the other surface.

In other words, it is preferable that in the groove-forming step, the bonding region be set on both the surfaces of the ceramic base board, at least the one or more scribe lines be formed on one surface of the ceramic base board and the one or more groove be formed on the other surface, and that in the joining step, the metal layers are formed on both the surfaces of the ceramic base board by joining the metal boards on the respective bonding regions.

In the above-stated aspect, the scribe line (the dividing groove) is formed on one surface of the ceramic base board and the groove is formed on the other surface; accordingly, comparing with a case in which the scribe line and the groove are formed only on one surface, a difference is smaller between the content of Si atoms diffused in the metal layer on the front surface side and the content of Si atoms diffused in the metal layer on the rear surface side. That is, the metal layers can be etched at substantially the same etching rate and both surfaces of the ceramic-metal joined body can be treated at the same time since the difference is small between the Si concentration of the metal layer at the front side and the Si concentration of the metal layer at the rear side of the ceramic base board.

In the method of manufacturing a ceramic-metal joined body for multi-piece of the present invention, it is preferable that, in the groove-forming step, the groove be formed inside a groove-forming region having an area of 80% or more of the bonding region, and a center of the groove-forming region coincide with a center of the bonding region.

In the above-stated aspect, the melted brazing material can be efficiently discharged from substantially a whole of the bonding region and the braze stains can be more prevented since the groove is formed in the groove-forming region having the area of 80% of the bonding region and the center of the groove-forming region coincides with the center of the bonding region.

A ceramic-metal joined body of the present invention is a ceramic-metal joined body in which a metal layer is joined on at least one surface of a ceramic substrate board, having a ceramic substrate in which a groove is formed to extend across a bonding region on which the metal layer is joined, and the metal layer made of aluminum or aluminum alloy having a thickness of 0.4 mm or less, joined on the bonding region of the ceramic substrate board by Al-Si type brazing material.

In other words, it is a ceramic-metal joined body provided with a ceramic substrate board having a bonding region which is set on at least one surface and a metal layer is joined and a groove extending across the bonding region, and the metal layer made of aluminum or aluminum alloy having a thickness of 0.4 mm or less and joined on the bonding region of the ceramic substrate board by Al-Si brazing material.

A ceramic-metal joined body for multi-piece of the present invention is a ceramic-metal joined body for multi-piece in which a metal layer is joined on at least one surface of a ceramic base board having a size which can be divided into a plurality of ceramic substrate boards, provided with a ceramic base board on which a groove extending across a bonding region on which the metal layer is joined and a scribe line dividing into ceramic substrate boards are formed; and the metal layer made of aluminum or aluminum alloy having a thickness of 0.4 mm or less, joined on the bonding region of the ceramic base board by Al-Si brazing material; and the metal layer is formed to have a size which covers a plurality of regions partitioned by the scribe line.

In other words, it is a ceramic-metal joined body for multi-piece having a ceramic base board provided with a bonding region on which a metal layer is bonded on at least one surface, a groove extending across the bonding region, and a scribe line (a dividing groove) to partition into a plurality of ceramic substrate board, and the metal layer which is made of aluminum or aluminum alloy having a thickness of 0.4 mm or less and joined on the bonding region of the ceramic base board by Al-Si brazing material; and the metal layer covers a plurality of regions partitioned by the scribe line.

### Advantageous Effects of Invention

According to the present invention, it is possible to suppress generation of braze stains formed on a surface of a metal layer joined on a ceramic substrate board.

### BRIEF DESCRIPTION OF DRAWINGS

FIG. 1 is a cross sectional view showing a cross section of a ceramic circuit substrate board according to a first embodiment of the present invention.
FIG. 2A is a view showing a manufacturing process (a groove-forming step) of the ceramic circuit substrate board in the first embodiment.
FIG. 2B is a view showing the manufacturing process (a bonding step) of the ceramic circuit substrate board in the first embodiment.
FIG. 2C is a view showing the manufacturing process of the ceramic circuit substrate board in the first embodiment.
FIG. 3 is a cross sectional view showing with magnifying a part of a ceramic substrate board on which a groove is formed in the first embodiment.
FIG. 4 is a plan view of the ceramic circuit substrate board on which the groove is formed in the first embodiment.
FIG. 5 is a plan view of a ceramic circuit substrate board divided by a groove according to a second embodiment of the present invention.
FIG. 6 is a plan view viewing a ceramic base board on which the grooves are formed from a front surface side in the second embodiment.
FIG. 7A is a view showing a manufacturing process (a groove-forming step) of a ceramic circuit substrate board in the second embodiment.
FIG. 7B is a view showing the manufacturing process (a bonding step) of the ceramic circuit substrate board in the second embodiment.
FIG. 7C is a view showing the manufacturing process (an etching step) of the ceramic circuit substrate board in the second embodiment.
FIG. 7D is a view showing the manufacturing process (a dividing step) of the ceramic circuit substrate board in the second embodiment.
FIG. 8 is a flow chart showing a method of manufacturing the ceramic circuit substrate board in the second embodiment.
FIG. 9 is a plan view of a ceramic base board on which grooves are formed viewed from a front surface side according to a modified example of the second embodiment.

### DESCRIPTION OF EMBODIMENTS

Embodiments of the present invention will be described below with reference to the drawings.

### -First Embodiment-

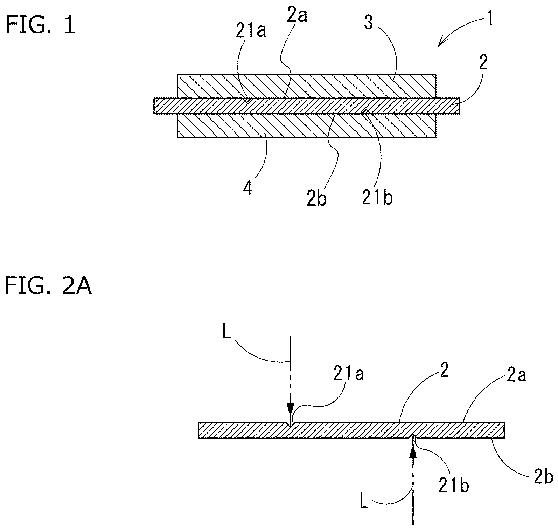

FIG. 1 is a cross sectional view showing a cross section of a ceramic circuit substrate board 1 of a first embodiment.

The ceramic circuit substrate board 1 corresponds to a ceramic-metal joined body of the present invention and formed to be a rectangle shape of vertical dimension 5 mm and a lateral dimension 5 mm in a plan view; and used as a wiring substrate board of a thermoelectric conversion element, for example. In the ceramic circuit substrate board 1, as shown in FIG. 1, a ceramic substrate board 2 and metal layers 3 and 4 joined on both sides of the ceramic substrate board 2 by brazing material are provided.

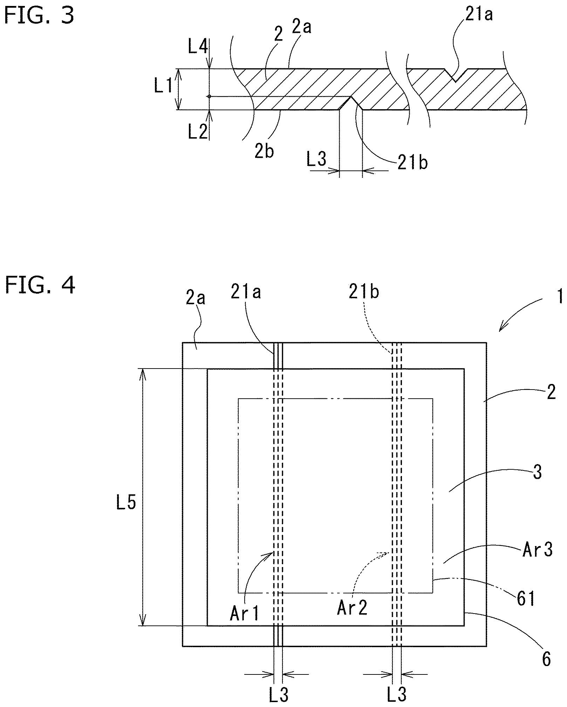

The ceramic substrate board 2 is made of ceramic material consisting of aluminum nitride (AlN), silicon nitride (Si₃N₄), alumina and the like and has substantially a square board material with the thickness L1 of 0.3 to 1.0 mm (refer to FIG. 3). On a front surface 2a and a rear surface 2b of the ceramic substrate board 2, grooves 21a and 21b are formed as shown in FIG. 1.

The metal layers 3 and 4 are substantially square boards made of pure aluminum or aluminum alloy having a thickness of 0.4 mm or less (e.g., 0.25 mm). As the metal layers 3 and 4, pure aluminum having a purity of 99.00% by mass or more, pure aluminum having a purity of 99.99% by mass or more, aluminum alloy of JIS 3003 or the like can be used.

The metal layers 3 and 4 are joined on the ceramic substrate board 2 with Al-Si type brazing material. The Si concentration in this brazing material is preferably 5% by mass to 12% by mass, and more preferably 7.5% by mass to 10.5% by mass. When the Si concentration in the Al-Si type brazing material is less than 5% by mass, a melting property due to heat is decreased, so that a bonding property may be deteriorated; and if the Si concentration is more than 12% by mass, the Al-Si type brazing material becomes hard and a rolling property may be deteriorated.

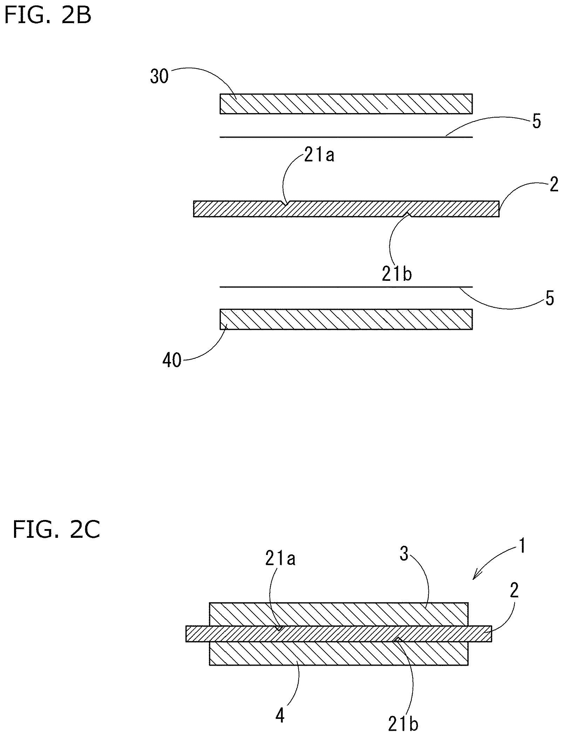

Next, a method of manufacturing the ceramic circuit substrate board 1 composed as above described will be explained. In this manufacturing method, the grooves 21a and 21b are formed on both surfaces 2a and 2b of the ceramic substrate board 2 as shown in FIG. 2A (a groove-forming step), and metal boards 30 and 40 to be the metal layers 3 and 4 are joined with Al-Si type brazing material 5 on both the surfaces 2a and 2b of the ceramic substrate board 2 as shown in FIG. 2B (a joining step), so that the ceramic circuit substrate board 1 that is a ceramic-metal joined body is manufactured as shown in FIG. 2C. The steps will be explained below in order.

### -Groove-forming Step-

First, as shown in FIG. 2A, in the ceramic substrate board 2 having a rectangular plate shape, the groove 21a is formed on the front surface 2a and the groove 21b on the rear surface 2b. As shown in this FIG. 2A, the grooves 21a and 21b are formed by removing the front surface 2a and the rear surface 2b of the ceramic substrate board 2 linearly by radiating laser light L, for example.

In the groove-forming step, the grooves 21a and 21b can be machined using CO2 laser, YAG laser, YVO4 laser, YLF laser, or the like, for example.

FIG. 3 is a cross sectional view magnifying a part of the ceramic substrate board 2 on which the groove 21b is formed; and FIG. 4 is a plan view of the ceramic circuit substrate board 1. The groove 21b on the rear surface 2b is magnified in FIG. 3.

As shown in FIG. 3, the grooves 21a and 21b having a depth dimension L2 and a width dimension L3 are formed on the front surface 2a and the rear surface 2b of the ceramic substrate board 2 having the thickness dimension L1 respectively. Accordingly, a thickness dimension L4 of a part on which the grooves 21a and 21b are formed in the ceramic substrate board 2 is smaller than the thickness dimension L1 of the ceramic substrate board 2 on which the ceramic substrate board 21a and the ceramic substrate board 21b are not formed.

For the ceramic substrate board 2 having the thickness L1 of 0.3 mm to 1.0 mm, it is preferable that the depth dimension L2 of the grooves 21a and 21b be 0.1 mm to 0.3 mm (<L1) and the width dimension L3 be 0.05 mm to 0.2 mm. For example in the present embodiment, the thickness L1 of the ceramic substrate board 2 is set to 0.635 mm; the depth L2 of the grooves 21a and 21b is set to 0.2 mm; the width L3 of the grooves 21a and 21b is set to 0.1 mm; and the remain thickness L4 of the ceramic substrate board 2 at the parts in which the grooves 21a and 21b are formed is set to 0.435 mm.

As shown in FIG. 4 viewing the front surface 2a, the groove 21a of the front surface 2a is a straight-linear groove, which is positioned at a left side of a center of the front surface 2a of the ceramic substrate board 2, and extending between an upper edge and a bottom edge of the front surface 2a in FIG. 4. The groove 21b on the rear surface 2b is a linear straight groove which is positioned at a right side of a center of the front surface 2a seeing from the front surface 2a side, extending between an upper edge and a lower edge of the surface 2a in FIG. 4. That is, the grooves 21a and 21b are arranged substantially in parallel with an interval and formed without overlapping.

On the front surface 2a and the rear surface 2b of the ceramic substrate board 2, substantially square bonding regions 6 to which the metal boards 30 and 40 are bonded are determined. Moreover, inside the bonding regions 6, substantially square groove-forming regions 61 are determined to have a center that coincides with the center of the bonding regions 6 and have an area of 80% of an area Ar3 of the bonding regions 6. The grooves 21 a and 21b are formed inside the groove-forming regions 61 as shown in FIG. 4. The grooves 21a and 21b are formed inside the groove-forming regions 61 so as to extend from edges to edges of the front surface 2a and the rear surface 2b of the ceramic substrate board 2. That is, the grooves 21a and 21b extend across the bonding regions 6 so that both ends thereof extend outside the bonding regions 6.

An opening area Ar1 (the wide dimension L3 of the groove 21a × a length L5 of the bonding regions 6) of the groove 21a on the front surface 2a is determined to be less than 5% of an area Ar3 (L5 × L5) of the bonding regions 6 on the front surface 2a. Similarly, an opening area Ar2 (the width dimension L3 of the groove 21b × the length L5 of the bonding regions 6) of the groove 21b on the rear surface 2b is determined to be less than 5% of the area Ar3 (L5 × L5) of the bonding regions 6 of rear surface 2b. That is, the groove 21a is formed on the front surface 2a so as to be Ar3 × 0.05 > Ar1. Similarly, the groove 21b is formed on the rear surface 2b so as to be Ar3 × 0.05 > Ar2.

It is desirable that the grooves 21a and 21b be formed so that at least one end is extended to an edge of the ceramic substrate board 2; however, it is not necessarily required that both the ends must extend to the edge of the ceramic substrate board 2. That is, it is enough that the grooves 21a and 21b extend outside the bonding regions 6 to a degree that the melted brazing material can be discharged outside the bonding regions 6 in a joining step explained below.

The ceramic substrate board 2 on which the grooves 21a and 21b are formed as above is cleansed with cleaning solvent, though illustration is omitted.

### -Joining Step-

Next, as shown in FIG. 2B, on the ceramic substrate board 2 cleansed after forming the grooves 21a and 21b, the metal boards 30 and 40 having a thickness of 0.4 mm or less are joined with Al-Si type brazing material (an Al-Si type brazing foil 5). Thereby, the ceramic circuit substrate board 1 shown in FIG. 2C in which the metal layers 3 and 4 are joined on the surfaces 2a and 2b of the ceramic substrate board 2 is formed.

Specifically, the metal boards 30 and 40 are layered on the bonding regions 6 in the front surface 2a and the rear surface 2b of the ceramic substrate board 2 with the Al-Si type brazing foils 5 therebetween respectively; and this layered body is held between carbon boards and heated in vacuum with a load in a laminate direction (maintained in a state of pressured), so that the metal boards 30 and 40 are joined on the ceramic substrate board 2.

The pressure in the laminate direction is preferably 0.1 MPa to 0.5 MPa; and heating temperature is preferably 630°C to 650°C. The Al-Si type brazing foil 5 has a thickness 5 µm to 15 µm preferably. However, the heating temperature is lower than the melting point of the metal boards 30 and 40. As the Al-Si type brazing material, Al-Si-Mg brazing material or the like can be used other than Al-Si brazing material and Al-Si-Cu brazing material.

If the grooves 21a and 21b are not formed on both the surfaces 2a and 2b of the ceramic substrate board 2, because the thickness of the metal layers 3 and 4 is thin as 0.4 mm or less, Si component included in the melted brazing material is diffused to surfaces of the metal layers 3 and 4 by layering the metal boards 30 and 40 made of aluminum or aluminum alloy on the bonding regions 6 with interposing the Al-Si type brazing material foil 5 and heating them with adding the load in the laminate direction, and braze stains are formed by generating a liquid phase on that surface.

By contrast, in the present embodiment, since the grooves 21a and 21b are formed on the ceramic substrate board 2 so as to extend across the bonding regions 6 of the ceramic substrate board 2 on which the metal layers 3 and 4 are joined, when the laminate body in which the metal boards 30 and 40 are layered on the bonding regions 6 of the ceramic substrate board 2 with the Al-Si type brazing material foil 5 therebetween is heated with the load in the laminate direction to join them, surplus melted brazing material is discharged outside the bonding regions 6 of the ceramic substrate board 2 through the grooves 21a and 21b, so that the generation of the braze stain can be prevented on the surfaces of the metal layers 3 and 4.

Here, it may be considered that if a thickness of the Al-Si type brazing material foil 5 is thinner the Si component of the melted brazing material can be suppressed so as not to diffused to the surfaces of the metal layers 3 and 4; however, there is a limit for rolling such an Al-Si type brazing material, and it is difficult to be 5 µm or less, for example. Moreover, it is difficult for Si content to be less than 5% by mass. Accordingly, when the laminate body in which the metal board 30 and the metal board 40 are layered on the bonding regions 6 of the ceramic substrate board 2 with the Al-Si type brazing material foil 5 therebetween is heated with the load in the laminate direction to join them, a volume of the melted brazing material is more than necessary, and the surplus is generated.

By contrast, in the present embodiment, the surplus melted brazing material is discharged outside the bonding regions 6, so that the Si component on a bonded surface is reduced and the braze stains can be suppressed.

Moreover, since the opening areas Ar1 and Ar2 of the grooves 21a and 21b are less than 5% of the area Ar3 of the bonding regions 6 of the front surface 2a and the rear surface 2b respectively, the metal boards 30 and 40 can be firmly joined on the front surface 2a and the rear surface 2b (the bonding regions 6) of the ceramic substrate board 2.

Furthermore, the melted brazing material can be efficiently discharged from substantially the whole bonding regions 6 since the grooves 21a and 21b are formed in the groove-forming regions 61 and the center of the groove-forming regions 61 coincides to the center of the bonding regions 6, so that the braze stains can be more suppressed.

### -Second Embodiment-

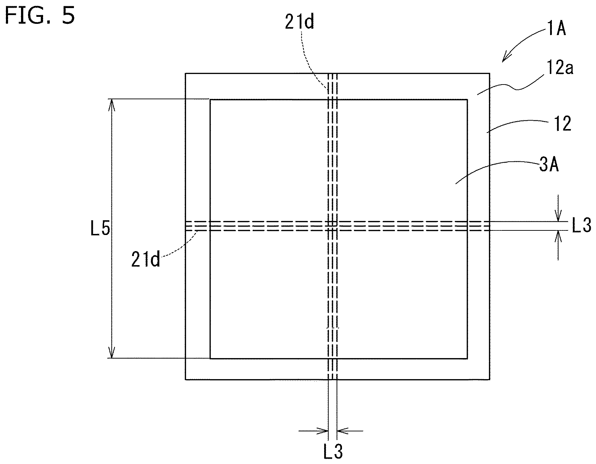

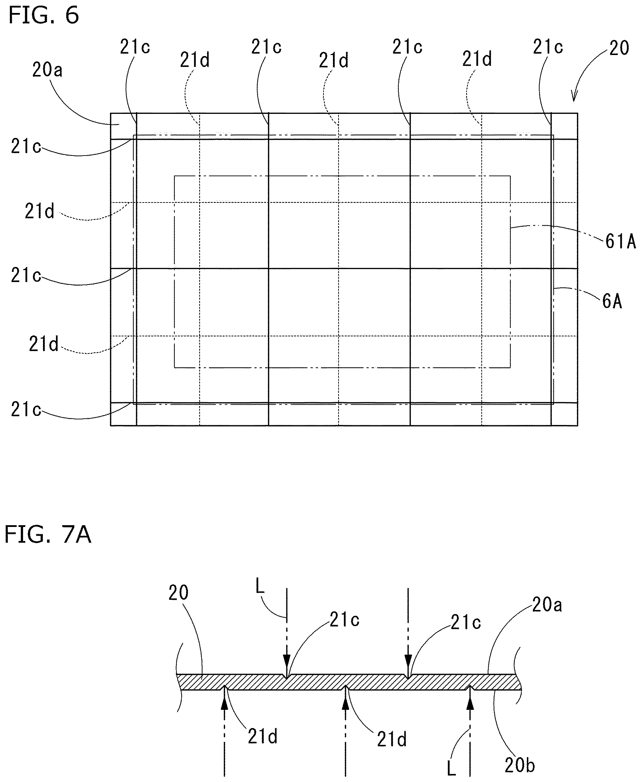

FIG. 5 is a plan view showing a ceramic circuit substrate board 1A according to a second embodiment of the present invention; and FIG. 6 is a plan view of a ceramic base board 20 on which grooves (scribe lines (dividing grooves) 21c and non-dividing grooves 21d) are formed viewed from a front surface 20a side.

The ceramic circuit substrate board 1A of the present embodiment is formed by a different producing method from the first embodiment: after the grooves (the scribe lines 21c and the non-dividing grooves 21d) are formed on both surfaces of the ceramic base board 20 having a size which can be divided into a plurality of ceramic substrate boards 12; metal boards 30A and 40A are layered and joined on both the surfaces of the ceramic base board 20 with Al-Si type brazing material foils interposed therebetween; and then the ceramic base board 20 is divided along the scribe lines 21c. Comparing each of the divided ceramic circuit substrate board 1A with the ceramic circuit substrate board 1 of the first embodiment, it is also different from the first embodiment in that the two non-dividing grooves 21d are formed only on a rear surface 12b.

As the non-dividing grooves 21d, as shown in FIG. 5, formed are a straight linear groove crossing a center of the rear surface 12b of the ceramic substrate board 12 and extending between an upper side and a lower side of the rear surface 12b; and a straight linear groove crossing the center of the rear surface 12b and extending between a left side and a right side of the rear surface 12b in FIG. 5.

The ceramic substrate boards 12 are formed by dividing the ceramic base board 20 shown in FIG. 6. The non-dividing grooves 21d are formed in a groove-forming region 61A in the rear surface 20b of the ceramic base board 20. The groove-forming region 61A has an area of 80% of an area of a bonding region 6A which is a region in which the metal board 40 is joined in the ceramic base board 20; and a center of the bonding region 6A coincides with a center of the groove-forming region 61A.

The non-dividing grooves 21d formed in the groove-forming region 61A are formed so that both ends thereof extend to both peripheral edges of the rear surface 20b of the ceramic base board 20. That is, the non-dividing grooves 21d extend across the bonding region 6A; and both the ends extend to an outside of the bonding region 6A.

An opening area (an opening area of the non-dividing grooves 21d extending in a vertical direction + an opening area of the non-dividing grooves 21d extending in a lateral direction - an area of regions where the non-dividing grooves 21d overlap each other) of the non-dividing grooves 21d in the bonding region 6A is less than 5% of an area of the bonding region 6A.

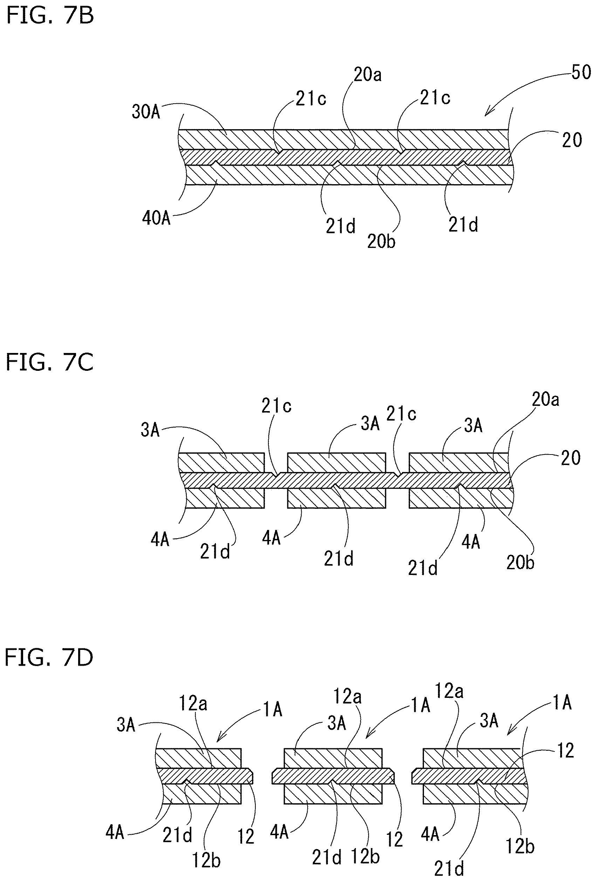

Next, a method of producing the ceramic circuit substrate board 1A will be explained. In this producing method, a ceramic-metal joined body 50 for multi-piece is produced first by preparing the ceramic base board 20 having the size which can form a plurality of the ceramic substrate boards 12, as shown in FIG. 7A to 7D, forming a plurality of grooves 21c and 21d on both the surfaces of the ceramic base board 20 (FIG. 7A), and bonding the metal boards 30A and 40A which will be the metal layers 3A and 4Aon both the surfaces of the ceramic base board 20 (FIG. 7B).

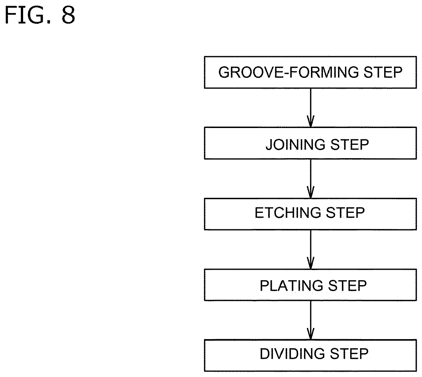

Then, the ceramic-metal joined body 50 for multi-piece is etched along the scribe lines 21c (FIG. 7C) and divided into pieces after plating (FIG. 7D), so that a plurality of the ceramic circuit substrate board 1A are produced. A groove-forming step, a joining step, an etching step, a plating step, and a dividing step will be explained in this order in detail hereinafter (refer to FIG. 8).

### --Groove-forming Step--

First, as shown FIG. 7A, the scribe lines 21c are formed on the front surface of the ceramic base board 20 having a rectangular board shape; and the non-dividing grooves 21d are formed on the rear surface 20b. As shown in FIG. 7A, the scribe lines 21c and the non-dividing grooves 21d are formed by, for example, radiating laser light L to linearly remove the front surface 20a and the rear surface 20b of the ceramic base board 20. The scribe lines 21c will be beginnings of dividing the ceramic base board 20 in the dividing step stated below.

A width dimension and a depth dimension of the non-dividing grooves 21d in the groove-forming step are the same as those of the groove 21b in the first embodiment: the width is 0.05 mm to 0.2 mm and the depth is 0.1 mm to 0.3 mm. A width dimension and a depth dimension of the scribe lines 21c are the same as the width dimension and the depth dimension of the non-dividing grooves 21d or larger than those of the non-dividing grooves 21d: for example, the width dimension is set to 0.05 mm to 0.3 mm and the depth dimension is set to 0.1 mm to 0.3 mm for the scribe lines 21c.

On the front surface 20a of the ceramic base board 20, as shown by solid lines in FIG. 6, the four scribe lines 21c extending in the vertical direction and the three scribe lines 21c extending in the lateral direction are formed. The four scribe lines 21c extending in the vertical direction are disposed with a prescribed interval in the lateral direction; and the three scribe lines 21c extending in the lateral direction are disposed with a prescribed interval in the vertical direction.

On the other, on the rear surface 20b of the ceramic base board 20, the three non-dividing grooves 21d extending along the vertical direction and the two non-dividing grooves 21d extending along the lateral direction are formed as shown by broken lines in FIG. 6. The three non-dividing grooves 21d extending in the vertical direction are disposed with a prescribed interval in the lateral direction to be departed from the four scribe lines 21c extending in the vertical direction disposed on the front surface 20a in a plan view of the ceramic base board 20. The two non-dividing grooves 21d extending in the lateral direction are disposed with a prescribed interval in the vertical direction to be departed from the three scribe lines 21c extending in the lateral direction disposed on the front surface 20a in the plan view.

As shown in FIG. 6, on the ceramic base board 20, the bonding region 6A having substantially a rectangular shape on which the metal boards 30A and 40A are joined is determined. Furthermore, inside the bonding region 6A, substantially the rectangular groove-forming region 61A having a center which coincides with a center of the bonding region 6A and having an area of 80% of an area of the bonding region 6A is provided. In the groove-forming step, the non-dividing grooves 21d are formed inside the groove-forming region 61A. The scribe lines 21c and the non-dividing grooves 21d which are in parallel to each other are formed with a prescribed interval.

Specifically, in the present embodiment, in order to form a plurality of the ceramic substrate boards 12 (the ceramic circuit substrate board 1A) of 10 mm square, the scribe lines 21c are formed with an interval of 10 mm on the front surface 20a of the ceramic base board 20 and the non-dividing grooves 21d are formed with an interval of 10 mm on the rear surface 20b; and the scribe lines 21c on the front surface 20a and the non-dividing grooves 21d on the rear surface 20b are disposed 5 mm apart from each other (5 mm intervals) in a surface direction of the ceramic base board 20. Therefore, in a silhouette of the ceramic base board 20 in the plan view, the scribe lines 21c arranged on the front surface 20a and the non-dividing grooves 21d arranged on the rear surface 20b are disposed alternately with 5 mm pitch in the vertical direction and the lateral direction respectively.

Outer peripheral parts of the ceramic base board 20 are margin parts and not used for the ceramic substrate boards 12. The ceramic base board 20 is divided along the scribe lines 21c in the dividing step stated below, and the six ceramic substrate boards 12 (the ceramic circuit substrate boards 1A) of 10 mm square in the plan view are formed.

### --Bonding Step--

Next, as shown in FIG. 7B, the metal boards 30A and 40A having a thickness dimension of 0.4 mm or less and a size covering six regions (regions to be the ceramic substrate boards respectively) separated by the scribe lines 21c are joined on the bonding region 6A of the ceramic base board 20 cleansed after forming the scribe lines 21c and the non-dividing grooves 21d using the Al-Si type brazing material. Thereby, the ceramic-metal joined body 50 for multi-piece in which the metal boards 30A and 40A are joined on the surfaces 20a and 20b of the ceramic base board 20 is formed.

Specifically, the metal boards 30A and 40A are layered with interposing the Al-Si type brazing material foil 5 on the bonding region 6A excepting the outer peripheral parts on both the surfaces of the ceramic base board 20; and the laminate body of these is held between the carbon boards and heated in vacuum with adding a load in the laminate direction, so that the metal boards 30A and 40A are joined to the ceramic base board 20.

In the present embodiment, as described above, the scribe lines 21c are formed on the front surface 20a which are four vertically and three laterally, and the non-dividing grooves 21d are formed on the rear surface 20b which are three vertically and two laterally; the number of these scribe lines 21c and the non-dividing grooves 21 can be substantially the same between the front surface 20a and the rear surface 20b. Therefore, when the laminate body is heated in the vacuum state in the bonding step, the surplus melted brazing material flows out from the laminate body along the scribe lines 21c on the front surface 20a and along the non-dividing grooves 21d on the rear surface 20b with substantially the same amount. As a consequence, substantially the same amount of melted brazing material is left between the ceramic base board 20 and the metal boards 30A and 40A, and the Si atoms of the melted brazing material are diffused into the metal boards 30A and 40A, so that the metal boards 30A and 40A contain substantially the same amount of Si atoms. As a result, the metal boards 30A and 40A have substantially the same Si concentration.

Moreover, since the surplus of the melted brazing material is discharged along the scribe lines 21c and the non-dividing grooves 21d to the outside from the laminate body (the outside of the bonding region 6A), and the generation of the braze stains can be suppressed on the surfaces of the metal boards 30A and 40A.

### --Etching Step--

The metal boards 30A and 40A joined on the ceramic base board 20 in the ceramic-metal joined body 50 for multi-piece are etched along the scribe lines 21c. The etching can be carried out by known techniques, for example, after masking necessary parts, etching is carried out using iron chloride solution. By etching, the metal layers 3A and 4A with substantially a rectangular shape in the plan view is formed. Thus, as shown in FIG. 7C, the metal layers 3A and 4A are provided in the respective regions partitioned by the scribe lines 21c on the ceramic base board 20.

In this case, the metal board 30A on the front surface 20a and the metal board 40A on the rear surface 20b of the ceramic base board 20 have the same Si concentration, so that the metal boards 30A and 40A can be etched with the same etching rate, and both surfaces of the ceramic-metal joined body 50 for multi-piece are etched at the same time.

### --Plating Step--

Then, plating treatment such as gold plating, silver plating, nickel plating and the like is applied to the ceramic-metal joined body 50 for multi-piece as necessary, though illustration is omitted. Thus, the ceramic-metal joined body 50 for multi-piece in which the metal layers 3A and 4A of the ceramic-metal joined body 50 for multi-piece are plated is produced.

Although both the surface of the ceramic-metal joined body 50 for multi-piece are plated in the present embodiment, it is not limited to this; for example, only one surface may be plated.

### --Dividing Step--

Finally, by dividing the ceramic base board 20 on which the metal layers 3A and 4A are joined along the scribe lines 21c, the ceramic base board 20 is separated into pieces, as shown in FIG. 7D, so that a plurality (six) of ceramic circuit substrate boards 1A are produced.

In addition, in the dividing step, on regions at an outermost peripheral side of the ceramic base board 20 (regions outside the scribe line 21c that is nearest to the outer peripheral of the ceramic base board 20), since braze lumps are formed by the surplus of the melted brazing material flowed out in the above-mentioned bonding step, the ceramic base board 20 is divided into pieces along the scribe lines 21c after removing the braze lumps in advance.

As describe above, in the producing method of the ceramic circuit substrate board 1A of the present embodiment, substantially the same number of the scribe lines 21c and the non-dividing grooves 21 are formed on both the surfaces (the front surface 20a and the rear surface 20b) of the ceramic base board 20. Accordingly, when the laminate body in which the metal boards 30A and 40A are laminated on both the front surface 20a and the rear surface 20b of the ceramic base board 20 is bonded using the Al-Si type brazing material, substantially the same amount of the surplus of the melted brazing material is discharged outside the laminate body on both the front surface 20a and the rear surface 20b along the scribe lines 21c and the non-dividing grooves 21d.

As a consequence, the content of the Si atoms diffused in the metal board 30A at the front surface 20a of the ceramic base board 20 and the content of the Si atoms diffused in the metal board 40A at the rear surface 20b are substantially the same. That is, since the metal board 30A at the front surface 20a and the metal board 40A at the rear surface 20b of the ceramic base board 20 have the same Si concentration, it is possible to etch the metal boards 30A and 40A at the same etching rate, and both surfaces of the ceramic-metal joined body 50 for multi-piece can be treated at the same time.

The non-dividing grooves 21d are formed inside the groove-forming region 61A and the center of the groove-forming region 61A coincides with the center of the bonding region 6A, so that the surplus of the melted brazing material can be efficiently discharged from substantially a whole of the bonding region 6A of the ceramic base board 20 and the generation of the braze stains can be more suppressed.

The present invention is not limited to the above-described embodiments and various modifications may be made without departing from the scope of the present invention.

For example, in the second embodiment stated above, the scribe lines 21c and the non-dividing grooves 21d are disposed with 10 mm interval; however, it is not limited to this, the disposure interval between the scribe lines 21c and the non-dividing grooves 21d can be modified appropriately in accordance with the size of the ceramic circuit substrate board 1. Moreover, the scribe lines 21c are formed on the front surface 20a of the ceramic base board 20 with four in vertical and three in lateral and the non-dividing grooves 21d are formed on the rear surface 20b with three in vertical and two in lateral; however, the number and the position can be modified appropriately in accordance with the size of the ceramic base board or the like. Furthermore, the scribe lines (dividing grooves) may be formed on both surfaces.

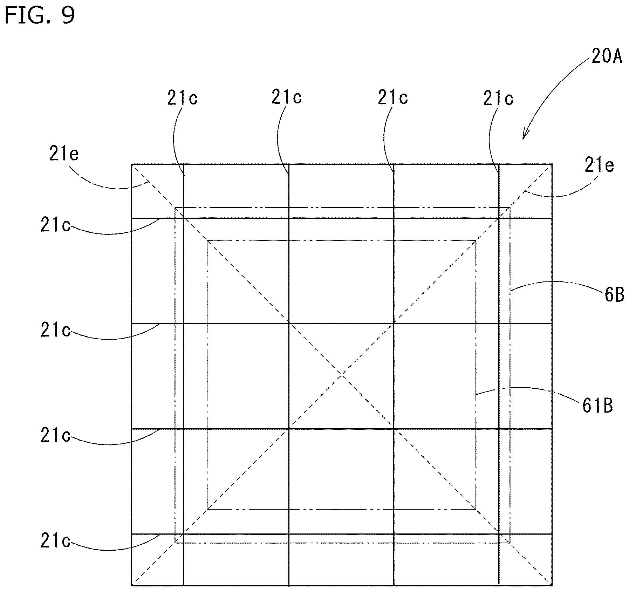

FIG. 9 is a plan view of viewing a front surface of a ceramic base board 20A according to a modified example of the second embodiment, on which grooves 21c and 21e are formed for producing a plurality of ceramic circuit substrate boards.

The ceramic base board 20A of this modified example is, as shown in FIG. 9, formed to have a size in which nine ceramic circuit substrate boards with 10 mm square in a plan view can be formed by being divided along the scribe lines 21c. On the front surface of the ceramic base board 20A, the four scribe lines 21 extending in the vertical direction and the four scribe lines 21c extending in the lateral direction as shown by the solid lines in FIG. 9. The four scribe lines 21c extending in the vertical direction are arranged with a prescribed interval in the lateral direction; and the four scribe lines 21c extending in the lateral direction are arranged with a prescribed interval in the vertical direction.

On the ceramic base board 20A, as shown in FIG. 9, substantially a square bonding region 6B on which a metal board is joined is determined. Moreover, inside the bonding region 6B, substantially a square groove-forming region 61B having a center coinciding with a center of the bonding region 6B and an area of 80% of an area of the bonding region 6B is determined.

On a rear surface of the ceramic base board 20, as shown by broken lines in FIG. 9, two non-dividing grooves 21e extending on diagonal lines of the ceramic base board 20A are formed. In this modified example, the non-dividing grooves 21e are formed across the groove-forming region 61B.

Metal boards are joined in the bonding regions 6B on both the surfaces of the ceramic base board 20A on which the scribe lines 21c and the non-dividing grooves 21e are formed, and it is divided along the scribe lines 21c into pieces; as consequence, five ceramic circuit substrate boards on which the non-dividing grooves 21e are formed are formed, and four ceramic circuit substrate boards on which the non-dividing grooves 21e are not formed are formed.

In the present modified example, since the non-dividing grooves 21e extend along the diagonal lines of the ceramic base board 20A, the ceramic base board 20A cannot be easily broken owing to the non-dividing grooves 21e.

Also in the present modified example, since the non-dividing grooves 21e are formed inside the groove-forming region 61B and the center of the groove-forming region 61B coincides with the center of the bonding region 6B, it is possible to discharge the melted brazing material from the bonding region along the scribe lines 21c and the non-dividing grooves 21e, so that the generation of the braze stains can be suppressed.

In the second embodiment, the ceramic circuit substrate board 1 is divided after plating; however, it is not limited to this, the plating on the ceramic circuit substrate board 1 may be carried out after the dividing step. Moreover, the plating treatment step is not always necessary.

In the second embodiment, the width dimension and the depth dimension of the scribe lines 21c are the same as or larger than the width dimension and the depth dimension of the non-dividing grooves 21d; however, it is enough that the non-dividing grooves are not larger than the scribe lines.

In the respective embodiments mentioned above, the grooves 21a and 21b, the scribe lines 21c, and the non-dividing lines 21d and 21e are formed by laser machining; however, it is not limited to this, for example, it can be carried out by other methods such as by a diamond scriber or the like.

### Examples

### --Examination Process--

In Examples 1 and 2 and Comparative Examples 1 and 2, on a surface of a ceramic base board having a rectangular board shape of 50 mm in the vertical direction × 50 mm in the lateral direction, formed were nine grooves with 5 mm interval in a vertical direction and nine grooves with 5 mm in a lateral direction which work as the scribe lines (dividing grooves).

In Examples 1 and 2, two grooves (non-dividing grooves) extending on diagonal lines of the ceramic base board were formed on a rear surface; but no grooves were formed on a rear surface in Comparative Examples.

A width dimension was 0.1 mm and a depth dimension was 0.15 mm in the scribe lines; and a width dimension was 0.05 mm and a depth dimension was 0.1 mm in the non-dividing grooves.

On bonding regions (49 mm in the vertical direction × 49 mm in the lateral direction) on both surfaces of the ceramic base board, metal boards with a thickness 0.1 mm and a composition shown in Table 1 were layered with interposing an Al-Si type brazing material foils with Si concentration 7.5% by mass and a sickness 12 µm; and a laminate body of them was held between carbon boards and heated in vacuum with adding a load in the laminate direction (in the pressed state); so that the ceramic base board and the metal boards were joined and a ceramic-metal joined body for multi-piece was produced. At this time, the pressure in the laminate direction was 0.3 MPa, heating temperature was 640°C, and the pressure time was 60 minutes.

On the respective surfaces of the ceramic-metal joined body for multi-piece, etching resists of 4 mm × 4 mm were formed in areas of 5 mm × 5 mm partitioned by the scribe lines. The etching resists were formed so that centers of the etching resists of 4 mm × 4 mm in a top view coincide with centers of the area of 5 mm × 5 mm in a top view. The etching resists were formed in the same patterns on the front surface and the rear surface of the ceramic-metal joined body for multi-piece.

Next, the ceramic-metal joined body for multi-piece was etched to divide the metal boards and form the metal layers; and the resists were removed. Iron chloride solution was used as etchant.

The width dimension of the partitioned metal layers after etching was measured; and a difference between an average value of the width dimension of the metal layers on the front surface and an average value of the width dimension of the metal layers on the rear surface (a difference of the width dimension of the metal layers after etching) was shown in Table 1. The width dimension of the partitioned metal layers was measured by measuring the any five metal layers by a dimension measuring instrument (an optical microscope); the front surface and the rear surface were measured at the same part.

**[Table 1]**

| | Metal Layers | Grooves | Difference of Width Dimension after Etching (mm) |
|---|---|---|---|
| Example 1 | 4N Aluminum | Both Surfaces | 0.03 |
| Example 2 | Aluminum Alloy JIS3003 | Both Surfaces | 0.04 |
| Comparative Example 1 | 4N Aluminum | Only One Surface | 0.08 |
| Comparative Example 2 | Aluminum Alloy JIS3003 | Only One Surface | 0.23 |

As known from results of Table 1, in Examples 1 and 2 in which the grooves were formed on both the surfaces of the ceramic base board, the difference of the width dimension of the metal layers after etching was 0.04 mm or less. That is, by forming the grooves on both the surfaces, the width (size) of the partitioned metal layers after etching were made even on the front surface and the rear surface respectively. Particularly, the effect was large when JIS3003 aluminum alloy was used as the metal layers.

In other words, by forming the grooves on both the surfaces of the ceramic base board, the surplus brazing material can be discharged from the joined parts; so it was confirmed that the metal boards on the both surfaces have substantially the same Si concentration and the etching rates were substantially equal on both the surfaces.

Moreover, the braze stains were not found on both the surfaces in Examples 1 and 2; however, the braze stains were generated on the rear surface without the grooves in Comparative Examples 1 and 2. That is, it was confirmed that the surplus of the brazing material can be discharged from the joined parts by forming the grooves and the braze stains can be prevented.

### Industrial Applicability

The etching rates of the metal boards joined on both surfaces of the ceramic substrate board can be even. The braze stains can be prevented on the surfaces of the metal layers joined on the ceramic substrate board.

### Reference Signs List

- 1, 1A: Ceramic circuit substrate board (Ceramic-metal joined body)
- 2, 12: Ceramic substrate board
- 2a, 12a: Front surface
- 2b, 12b: Rear surface
- 3, 4, 3A, 4A: Metal layer
- 5: Al-Si type brazing material foil
- 6, 6A, 6B: Bonding region
- 61, 61A, 61B: Groove-forming region
- 20, 20A: Ceramic base board
- 20a: Front surface
- 20b: Rear surface
- 21a, 21b: Groove
- 21d, 21e: Non-dividing groove (Groove)
- 21c: Scribe line (Dividing groove)
- 30, 40: Metal board
- 50: Ceramic-metal joined body for multi-piece

## Claims

1. A method of manufacturing a ceramic-metal joined body wherein a metal layer is joined on at least one surface of a ceramic substrate board, comprising
a groove-forming step forming a groove across a bonding region in which the metal layer is joined on the ceramic substrate board, and
a joining step after the groove-forming step wherein the metal layer is formed by layering a metal board made of aluminum or aluminum alloy having a thickness of 0.4 mm or less on the bonding region of the ceramic substrate board with interposing an Al-Si type brazing material foil, and heating with adding a load in a laminate direction to bond the metal board on the bonding region.

2. The method of manufacturing a ceramic-metal joined body according to claim 1, wherein the groove is formed in the groove-forming step so that an open area of the groove in the bonding region is less than 5% of an area of the bonding region.

3. The method of manufacturing a ceramic-metal joined body according to claim 1 or 2, wherein in the groove-forming step, the groove is formed inside a groove-forming region having an area of 80% of the bonding region of the ceramic substrate board, and a center of the groove-forming region coincides with a center of the bonding region.

4. The method of forming a ceramic-metal joined body according to any one of claims 1 to 3, wherein an Si concentration in the Al-Si type brazing material foil is not less than 5% by mass and not more than 12% by mass.

5. A method of manufacturing a ceramic-metal joined body for multi-piece in which a metal layer is joined on at least one surface of a ceramic base board having a size which can be divided into a plurality of ceramic substrates, comprising
a groove-forming step forming a groove to extend across a bonding region of the ceramic base board on which the metal layer is joined and forming a scribe line to divide the ceramic base board and form the ceramic substrate boards; and
a joining step forming the metal layer after the groove-forming step, wherein a metal board made of aluminum or aluminum alloy having a thickness of 0.4 mm or less is layered on the bonding region of the ceramic base board with interposing an Al-Si type brazing material foil, and the metal board is joined on the bonding region by heating with adding a load in a laminate direction, wherein
the metal board is formed to have a size covering a plurality of regions partitioned by the scribe line.

6. The method of manufacturing a ceramic-metal joined body for multi-piece according to claim 5, wherein
the ceramic base board has the bonding region on both surfaces, and
in the groove-forming step, the scribe line is formed on one of the surfaces of the ceramic base board, and the groove is formed on the other surface.

7. The method of manufacturing a ceramic-metal joined body for multi-piece according to claim 5 or 6, wherein in the groove-forming step, the groove is formed inside a groove-forming region having an area of 80% or more of the bonding region, and a center of the groove-forming region coincides with a center of the bonding region.

8. A ceramic-metal joined body in which a metal layer is joined on at least one surface of a ceramic substrate board, comprising
a ceramic substrate in which a groove is formed to extend across a bonding region on which the metal layer is joined, and
the metal layer made of aluminum or aluminum alloy having a thickness of 0.4 mm or less, joined on the bonding region of the ceramic substrate board by Al-Si type brazing material.

9. A ceramic-metal joined body for multi-piece in which a metal layer is joined on at least one surface of a ceramic base board having a size which can be divided into a plurality of ceramic substrate boards, comprising
a ceramic base board on which a groove extending across a bonding region on which the metal layer is joined and a scribe line dividing into ceramic substrate boards are formed; and
the metal layer made of aluminum or aluminum alloy having a thickness of 0.4 mm or less, joined on the bonding region of the ceramic base board by Al-Si brazing material, wherein
the metal layer is formed to have a size which covers a plurality of regions partitioned by the scribe line.
